(19) Europäisches Patentamt

European Patent Office

Office européen des brevets

(11) EP 1 712 924 A1

(12) EUROPEAN PATENT APPLICATION
published in accordance with Art. 158(3) EPC

(43) Date of publication:
18.10.2006 Bulletin 2006/42

(51) Int Cl.:
$G01R\ 31/36^{(2006.01)}$

(21) Application number: 05703907.5

(86) International application number:
PCT/JP2005/000679

(22) Date of filing: 20.01.2005

(87) International publication number:
WO 2005/071427 (04.08.2005 Gazette 2005/31)

(84) Designated Contracting States:
DE FR GB IT

(30) Priority: 21.01.2004 JP 2004013363

(71) Applicant: YAZAKI CORPORATION
Minato-ku,
Tokyo 108-0073 (JP)

(72) Inventor: ARAI, Youichi
c/o Yazaki Corporation
Shizuoka 4101107 (JP)

(74) Representative: Viering, Jentschura & Partner
Steinsdorfstrasse 6
80538 München (DE)

(54) BATTERY PURE RESISTANCE MEASURING METHOD AND APPARATUS

(57) The present invention provides a method of measuring an intrinsic resistance of a battery at a low rate discharge and an apparatus of the same. A method of measuring an intrinsic resistance of a battery includes the steps of: measuring periodically a discharge current and a terminal voltage responding to the discharge current at a low rate discharge of the battery; determining a first approximate expression of the terminal voltage with respect to the increasing discharge current and a second approximate expression of the terminal voltage with respect to the decreasing discharge current based on the measured discharge current and terminal voltage; defining a range of the intrinsic resistance based on the first and second approximate expressions; assuming a resistance in the range of the intrinsic resistance as a tentative intrinsic resistance; determining a tentative maximum polarization time from the second approximate expression and the tentative intrinsic resistance; and determining the intrinsic resistance from two relational expressions including the intrinsic resistance, an intrinsic maximum polarization time and the tentative maximum polarization time.

PROCESS FOR MEASURING INTRINSIC RESISTANCE

ACQUIRE I−V CHARACTERISTIC OF INCREASING DISCHARGE CURRENT & CALCULATE CURRENT INCREASING CURVE L 1 — S 1

ACQUIRE I−V CHARACTERISTIC OF DECREASING DISCHARGE CURRENT & CALCULATE CURRENT INCREASING CURVE L 2 — S 2

$R_1 = 2a_1I_p + b_1$ — S 3

$R_2 = 2a_2I_p + b_2$ — S 4

$\dfrac{R_1+R_2}{2} > R > R_2$ — S 5

$R_t = (R_1 + 3R_2)/4$ — S 6

$I_{maxt} = (b_2 - R_t)\,2a_2$ — S 7

$R = \dfrac{t_1+\gamma}{t_1+t_{2'}}\alpha + \dfrac{t_{2'}-\gamma}{t_1+t_{2'}}\beta$ — S 8

$R = 2a_2I_p \times \dfrac{t_{2'}-\gamma}{t_{2'}} + b_2$ — S 9

CALCULATE R, $\gamma$ — S 10

END

F I G. 2

EP 1 712 924 A1

## Description

### Technical Field

The present invention relates to a method of measuring an intrinsic resistance of a battery which supplies electric power to loads of a vehicle, and an apparatus of the same.

### Related Art

When an engine of a vehicle is started with a starter, an inrush current flows through the starter. The inrush current has a very high current with a short period of time compared with a steady current.

The short period of time means that a polarization can be well correlated with a discharge current. The high current means that the polarization can be reliably determined with accuracy of voltage and current. In the case of a lead battery, the short period of time means at most 400msec and the inrush current is at least 3C.

JP,2003-115331,A discloses a method of measuring an intrinsic resistance of a battery at a high rate discharge of the inrush current.

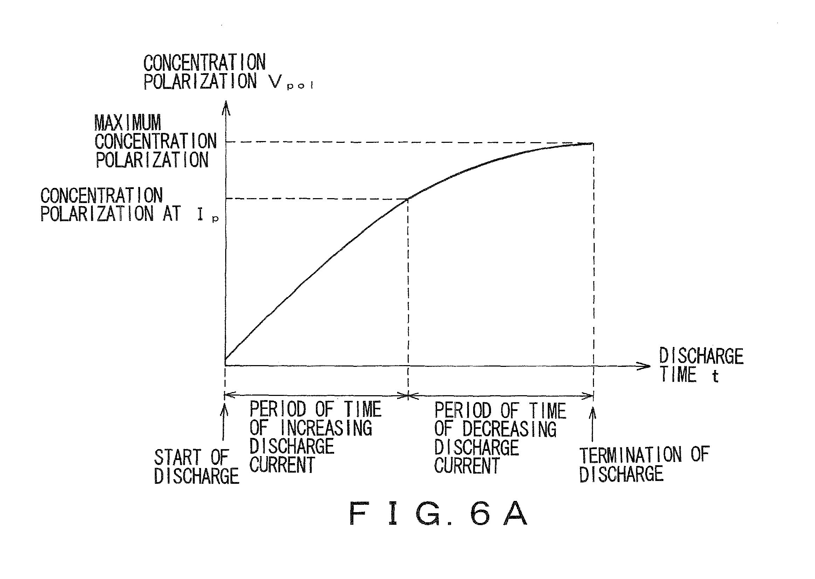

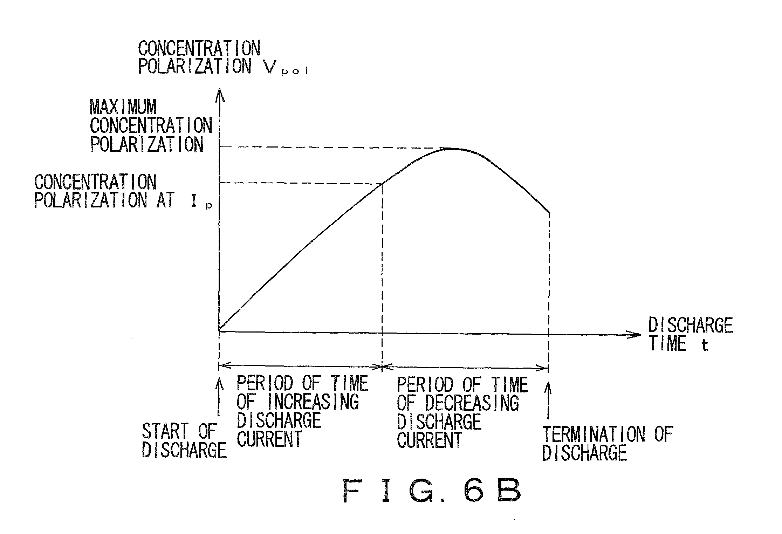

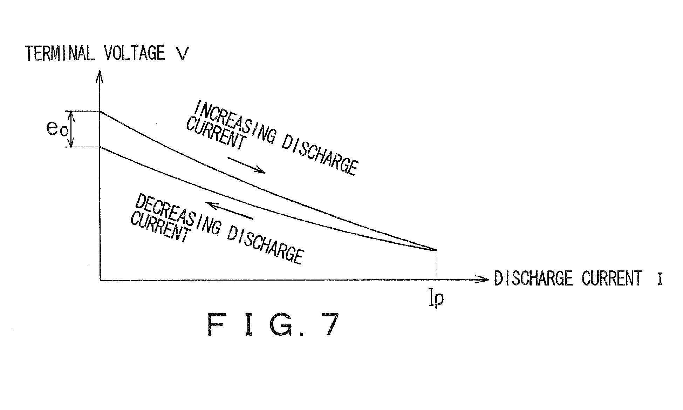

The method is explained by referring to FIGS. 6 and 7. As shown in FIG. 6A, when a high rate discharge starts, a concentration polarization increases until a discharge current reaches to a peak current $I_p$. When the discharge current starts to decrease, the concentration polarization can not decrease concurrently due to late response. Accordingly, the concentration polarization continues to increase for a while and decrease. In the case of the high rate discharge with a short period of time, the concentration polarization becomes a maximum value at a time when the high rate discharge is terminated.

High-rate sampling of the discharge current and a terminal voltage provides I-V characteristics as shown in FIG. 7. A difference $e_0$ of the terminal voltage between the start and end of the discharge is the maximum value of the concentration polarization. The concentration polarization at the peak current $I_p$ is determined by utilizing the maximum concentration polarization $e_0$. The determined concentration polarization is subtracted from the I-V characteristic of the discharge current and terminal voltage so that I(the discharge current)-V(a voltage drop of the battery due to the intrinsic resistance and activation polarization) characteristic is determined. The intrinsic resistance is determined from the voltage drop characteristic by utilizing a difference of characteristics between the activation polarization and the intrinsic resistance.

The above method can determine the intrinsic resistance every time when the high rate discharge is generated.

Under a circumstance of use of a battery, there is a case that a high rate discharge does not occur. A measurement of an intrinsic resistance at a low rate discharge, a current of at least 3C, is requested.

The low rate discharge of the current of 1C-3C induces a concentration polarization smaller than the case of the high rate discharge and then the concentration polarization disappears faster when the discharge current decreases. Accordingly, as shown in FIG. 6B, the concentration polarization does not show the maximum at the termination of the discharge in contrast to the high rate discharge.

Then, the measurement of the intrinsic resistance of the battery at the low rate discharge as described in JP, 2003-115331,A does not give high measurement accuracy.

### Disclosure of the Invention

The present invention is to provide a method of measuring an intrinsic resistance of a battery at a low rate discharge and an apparatus of the same.

According to a first aspect of the present invention, a method of measuring an intrinsic resistance of a battery includes the steps of: measuring periodically a discharge current and a terminal voltage responding to the discharge current at a low rate discharge of the battery; determining a first approximate expression of the terminal voltage with respect to the increasing discharge current and a second approximate expression of the terminal voltage with respect to the decreasing discharge current based on the measured discharge current and terminal voltage; defining a range of the intrinsic resistance based on the first and second approximate expressions; assuming a resistance in the range of the intrinsic resistance as a tentative intrinsic resistance; determining a tentative maximum polarization time from the second approximate expression and the tentative intrinsic resistance; and determining the intrinsic resistance from two relational expressions including the intrinsic resistance, an intrinsic maximum polarization time and the tentative maximum polarization time.

The method of measuring the intrinsic resistance of the battery includes the steps of: measuring periodically the discharge current and the terminal voltage responding to the discharge current at the low rate discharge of the battery; determining the first approximate expression of the terminal voltage with respect to the increasing discharge current and the second approximate expression of the terminal voltage with respect to the decreasing discharge current based on the measured discharge current and terminal voltage; defining the range of the intrinsic resistance based on the first and second approximate expressions; assuming the resistance in the range of the intrinsic resistance as the tentative intrinsic resistance; determining the tentative maximum polarization time from the second approximate expression and the tentative intrinsic resistance; determining the intrinsic resistance from two relational expressions including the intrinsic resistance, the intrinsic maximum polarization time and the tentative maximum polarization time; and solving simultaneous equations of the two relational expressions to obtain the intrinsic resistance.

The two relational expressions comprise: a first relational expression given by equating the intrinsic resistance to a formula of { (a period of time between a start of discharge and the intrinsic maximum polarization time)/(a period of time between the start of discharge and the tentative maximum polarization time)}×(a maximum value in the range of the intrinsic resistance) + {(a period of time between the intrinsic maximum polarization time and the tentative maximum polarization time)/(the period of time between the start of discharge and the tentative maximum polarization time)}×(a minimum value in the range of the intrinsic resistance); and a second relational expression given by equating the intrinsic resistance to a formula of a differential equation of the second approximate expression substituted the discharge current with a current of a formula of (a peak current)×{(the period of time between the intrinsic and tentative maximum polarization times)/(a period of time between a peak current time and the tentative maximum polarization time).

The two relational expressions comprise: the first relational expression given by equating the intrinsic resistance to the formula of {(the period of time between the start of discharge and the intrinsic maximum polarization time)/(the period of time between the start of discharge and the tentative maximum polarization time)}×(the maximum value in the range of the intrinsic resistance) + { (the period of time between the intrinsic maximum polarization time and the tentative maximum polarization time)/(the period of time between the start of discharge and the tentative maximum polarization time)}×(the minimum value in the range of the intrinsic resistance); and the second relational expression given by equating the intrinsic resistance to the formula of the differential equation of the second approximate expression substituted the discharge current with the current of the formula of (the peak current)×{(the period of time between the intrinsic and tentative maximum polarization times)/(the period of time between the peak current time and the tentative maximum polarization time). Accordingly, the intrinsic resistance is accurately obtained.

The method further includes the steps of: differentiating the first approximate expression with respect to the discharge current to obtain a first amount of change; differentiating the second approximate expression with respect to the discharge current to obtain a second amount of change; and defining the range of the intrinsic resistance between (the first amount of change + the second amount of change)/2 and (the second amount of change) at the peak current.

Accordingly, the range of the intrinsic resistance is further defined.

Preferably, the center value of the range of the intrinsic resistance is the tentative intrinsic resistance.

Accordingly, the difference between the intrinsic resistance and tentative intrinsic resistance becomes small.

An apparatus for measuring an intrinsic resistance of a battery includes: a current sensor for measuring a discharge current of a battery at a low rate discharge; a voltage sensor for measuring a terminal voltage of the battery responding to the discharge current; an interface circuit for converting the measured voltage from analog to digital; and a microcomputer having a CPU, a RAM and a ROM, wherein the CPU receives data of the measured current and voltage from the interface circuit; calculates a first approximate expression of the terminal voltage with respect to the increasing discharge current and a second approximate expression of the terminal voltage with respect to the decreasing discharge current from the measured discharge current and terminal voltage; defines a range of the intrinsic resistance from the first and second approximate expressions; assumes a resistance in the range of the intrinsic resistance as a tentative intrinsic resistance; determines a tentative maximum polarization time from the second expression and the tentative intrinsic resistance; and determines the intrinsic resistance from two relational expressions including the intrinsic resistance, an intrinsic maximum polarization time and the tentative maximum polarization time.

The apparatus for measuring the intrinsic resistance of the battery includes: the current sensor for measuring the discharge current of the battery at the low rate discharge; the voltage sensor for measuring the terminal voltage of the battery responding to the discharge current; the interface circuit for converting the measured voltage from analog to digital; and the microcomputer having the CPU, RAM and ROM, wherein the CPU receives data of the measured current and voltage from the interface circuit; calculates the first approximate expression of the terminal voltage with respect to the increasing discharge current and the second approximate expression of the terminal voltage with respect to the decreasing discharge current from the measured discharge current and terminal voltage; defines the range of the intrinsic resistance from the first and second approximate expressions; assumes the resistance in the range of the intrinsic resistance as the tentative intrinsic resistance; determines the tentative maximum polarization time from the second expression and the tentative intrinsic resistance; determines the intrinsic resistance from two relational expressions including the intrinsic resistance, the intrinsic maximum polarization time and the tentative maximum polarization time; and solves the two simultaneous relational expressions to obtain the intrinsic resistance.

**Brief Description of the Drawings**

FIG. 1 is a block diagram of a configuration of an in-vehicle unit for measuring an intrinsic resistance of a battery of the present invention;

FIG. 2 is a flowchart showing a processing order of a CPU 23a of the in-vehicle unit of FIG. 1;

FIG. 3 shows a current increasing curve $L_1$ and current decreasing curve $L_2$ at a low rate discharge;

FIG. 4 shows a relation between tangential angles $\alpha$, $\beta$ and a tentative intrinsic resistance $R_t$;

FIG. 5 shows polarization curves $L_5$ and $L_6$ for the tentative and intrinsic resistances $R_t$ and $R$, respectively, of $V_p$-t characteristic, where $V_p$ is polarization and t is a discharge time;

FIG. 6A is $V_{pol}$(concentration polarization)-t(discharge time) characteristic at a high rate discharge;

FIG. 6B is $V_{pol}$-t characteristic at the low rate discharge; and

FIG. 7 is I(discharge current)-V(terminal voltage) characteristic at the high rate discharge.

**Best Mode for Carrying out the Invention**

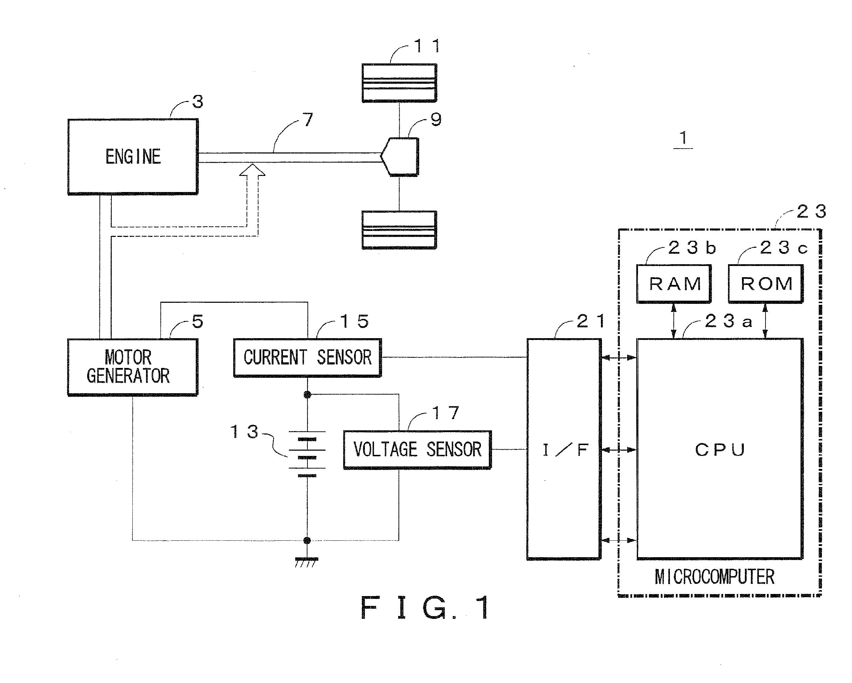

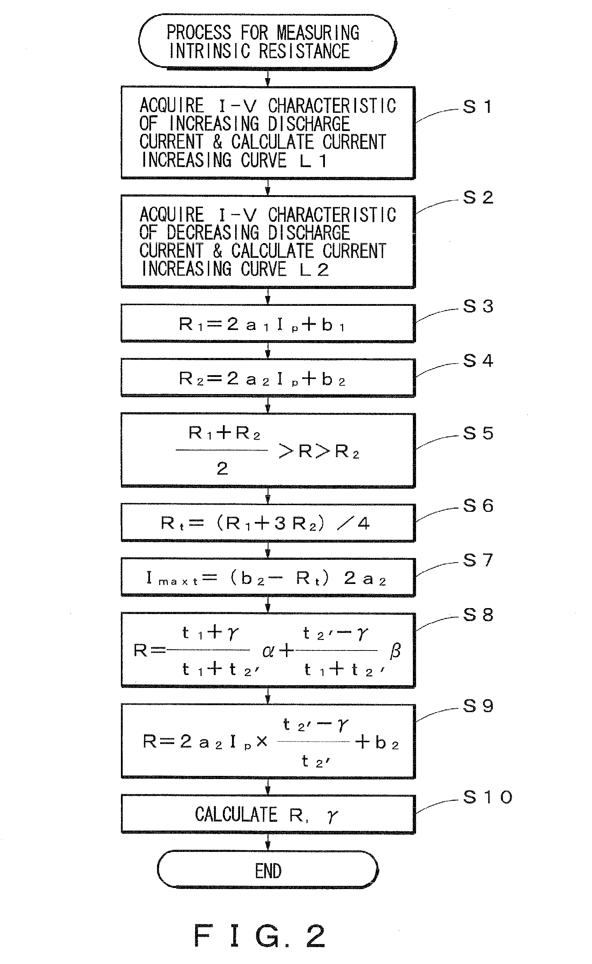

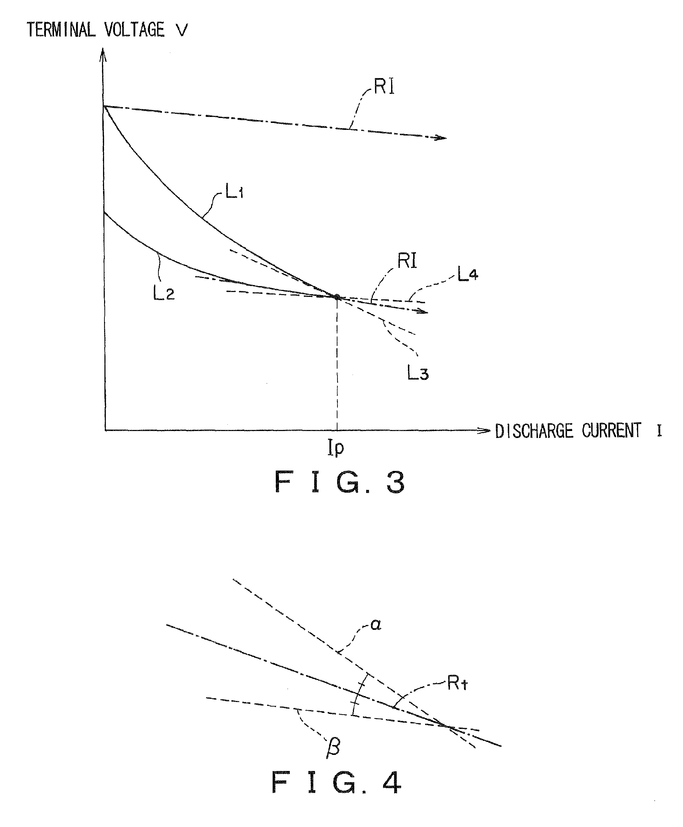

FIGS. 1 and 2 show an apparatus of measuring an intrinsic resistance of a battery of the present invention. A method of the measurement is explained by referring to FIGS. 3-5.

A low rate discharge discharges a low discharge current (about 1C-3C) for a short period of time for a hour rate capacity of the battery. At the low rate discharge, the discharge current increases monotonically from zero to a peak value and decreases in a short period of time and reaches to a steady value corresponding to a load. In the low rate discharge, a concentration polarization reaches to a maximum value prior to the termination of the discharge as shown in FIG. 6B.

The discharge current and terminal voltage of the battery are measured every a certain period of time at the low rate discharge with increasing and decreasing discharge currents. The measured pairs of the discharge currents I and terminal voltages V are fitted into quadratic approximate expressions of

$$V = a_1 I^2 + b_1 I + c_1 \quad \text{(a current increasing curve)} \quad \text{Eq. 1}$$

and

$$V = a_2 I^2 + b_2 I + c_2 \quad \text{(a current decreasing curve)} \quad \text{Eq. 2.}$$

Eqs. 1 and 2 are denoted as a first approximate expression and second approximate expression, respectively. In FIG. 3, L1 and L2 show the current increasing and decreasing curves, respectively.

Eqs. 1 and 2 are differentiated and a peak current $I_p$ is substituted in the differentiated equations to obtain a change of the terminal voltage per unit discharge current at $I_p$ and a change of an internal resistance (=intrinsic resistance+concentration polarization resistance+activation polarization resistance) at $I_p$. The change of resistance at the increasing and decreasing currents are expressed with

$$R_1 = 2a_1 I_p + b_1 \quad \text{Eq. (3)}$$

and

$$R_2 = 2a_2 I_p + b_2 \quad \text{Eq. (4),}$$

respectively. The $R_1$ and $R_2$ are denoted as a first amount of change and a second amount of change at the peak current $I_p$, respectively.

The $R_1$ and $R_2$ are angles of tangential lines $L_3$ and $L_4$ of the first and second approximate expressions $L_1$ and

$L_2$ at the peak current $I_p$. The relation between $R_1$, $R_2$ and the intrinsic resistance R is explained.

The intrinsic resistance R is not related with chemical reactions and is constant unless the state of charge (SOC) and the temperature of the battery change. Then, the intrinsic resistance R is assumed to be constant at the low rate discharge so that the voltage drop RI due to the intrinsic resistance R is expressed by a dash-dotted line RI of FIG. 3.

The polarization (activation + concentration) increases with increase of the discharge current I and then the current increasing curve $L_1$ deviates downwardly from the voltage drop RI. Then, the angle $R_1$ of the tangential line $L_3$ at $I_p$ of the curve $L_1$ is larger than the slope of RI, that is $R_1 > R$.

The response of the above polarization is slow so that it still increases for a while and then decreases with decrease of the discharge current I. Accordingly, the current decreasing curve $L_2$ further deviates from the voltage drop RI and approaches to the potential drop RI.

The current decreasing curve $L_2$ departs further from the voltage drop RI so that the angle $R_2$ of the tangential line $L_4$ of the current decreasing curve $L_2$ at the peak current $I_p$ is smaller than that of the voltage drop RI, that means $R_2 < R$.

As shown in FIG. 6B, at the low rate discharge, the polarization increases after the discharge current decreases but the increasing amount is small compared with the amount that the increasing discharge current generates. Hence, the difference of the angle of the tangential lines between $R_1$-R is larger than that between R-$R_2$, namely $R_1$-R>R-$R_2$. Then, a range of the intrinsic resistance is defined by

$$\{(R_1 + R_2)/2\} > R > R_2 \qquad \text{Eq. 5.}$$

Hereafter, it is denoted $(R_1 + R_2)/2 = \alpha$, $R_2 = \beta$.

The intrinsic resistance R can also be in the range of $R_1 > R > R_2$. The narrower range of the intrinsic resistance R of Eq. 5 provides a more accurate value.

Suppose that the intrinsic resistance R is the center value of $\alpha$ and $\beta$, the value (a tentative intrinsic resistance) becomes

$$R_t = (\alpha + \beta)/2 = (R_1 + 3R_2)/4 \qquad \text{Eq. 6.}$$

As shown in FIG. 4, the tentative intrinsic resistance $R_t$ is in the middle value of the angles of $\alpha$ and $\beta$.

The tentative intrinsic resistance $R_t$ may not be in the center between $\alpha$ and $\beta$. It is assumed that the center value provides a more accurate intrinsic resistance of the battery.

The polarization shows the maximum value when the discharge current decreases. The subtraction of the voltage drop $R_t I$ of the tentative intrinsic resistance $R_t$ from the current decreasing curve $L_2$ gives a voltage drop $V_p$ originating from only the polarization as given by

$$V_p = (a_2 I^2 + b_2 I + c_2) - R_t I = a_2 I^2 + \{b_2 - (R_1 + 3R_2)/4\} I + c_2 \qquad \text{Eq. 7.}$$

Differentiating Eq. 7 with the discharge current I becomes the equation,

$$dV_p/dI = 2a_2 I + \{b_2 - (R_1 + 3R_2)/4\}.$$

Equating the differential equation to zero gives a tentative discharge current $I_{maxt}$ at which the polarization of the internal resistance excluding the tentative intrinsic resistance $R_t$ becomes the maximum value. The equations are given by

$$2a_2 I_{maxt} + \{b_2 - (R_1 + 3R_2)/4\} = 0$$

and

$$I_{maxt}=\{b_2-(R_1+3R_2)/4\}/2a_2 \qquad Eq. \quad 8.$$

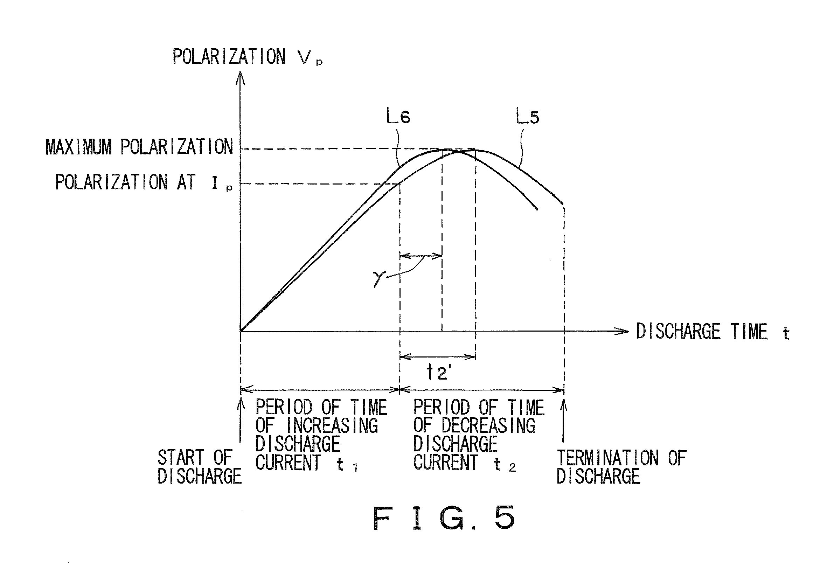

A relation between a discharge time t and the intrinsic resistance $R_t$ is explained below. FIG. 5 is a graph of the discharge time t and the polarization $V_p$ at the low rate discharge. In FIG. 5, $t_1$ denotes a period of time between the start and the peak current $I_p$ of the discharge current and $t_2$ denotes a period of time between the peak current $I_p$ and the termination of the discharge current.

A polarization curve $L_5$ shows a relation between the polarization $V_p$ and the discharge current t for the tentative intrinsic resistance $R_t$ and the polarization curve $L_6$ shows a relation between the polarization $V_p$ and the discharge time t for the intrinsic resistance R.

In FIG. 5, $t_2$, denotes a period of time between the peak current $I_p$ and the tentative maximum polarization time of the tentative intrinsic resistance $R_t$ of the discharge time t. The $t_2$, is determined from the measured pair of data and $I_{maxt}$ of Eq. 8. A $\gamma$ denotes a period of time between the peak current $I_p$ and an intrinsic maximum polarization time of the discharge time.

The intrinsic resistance R approaches to $\alpha$ as $(t_1+\gamma)$ further occupies the period of time $(t_1+t_2,)$ and approaches to $\beta$ as $(t_2,-\gamma)$ further occupies the period of time $(t_1+t_2,)$. The intrinsic resistance R is given by

$$R=\{(t_1+\gamma)/(t_1+t_2,)\}\alpha+\{(t_2,-\gamma)/(t_1+t_2,)\}\beta \qquad Eq. \quad 9.$$

Eq. 9 is referred to a first relational expression.

The change of the current decreasing curve with respect to the discharge current is given by the equation

$$dV/dI=2a_2I+b_2 \qquad Eq. \quad 10.$$

The change of the polarization becomes zero at the maximum polarization and the change of the current decreasing curve $L_2$ becomes equal to the intrinsic resistance R. When $I_{max}$ is assumed to be a current having the maximum polarization and is substituted in Eq. 10, the result gives the intrinsic resistance R as a formula

$$2a_2I_{max}+b_2=R.$$

The $I_{max}$ approaches to $I_p$ as the time $\gamma$ becomes small in the period of the time $t_2$,. Then $I_{max}$ is given by

$$I_{max}=I_p(t_2,-\gamma)/t_2, \qquad Eq. \quad 11.$$

Substitution of Eq. 11 to the formula $2a_2I_{max}+b_2=R$ gives a formula

$$R=2a_2I_p\{(t_2,-\gamma)/t_2,\}+b_2 \qquad Eq. \quad 12.$$

Eq. 12 is referred to a second relational expression.

Unknowns in Eqs. 9 and 12 are the intrinsic resistance R and $\gamma$. Then, the solutions of the simultaneous Eqs. 9 and 12 give the value of R and $\gamma$. Accordingly, the intrinsic resistance is obtained even at the low rate discharge.

The intrinsic resistance of the battery is measured with a configuration schematically shown in FIG. 1.

FIG. 1 shows a block diagram of the configuration of an in-vehicle unit 1 for the intrinsic resistance measurement of the battery of the present invention. The in-vehicle unit 1 is mounted to a hybrid vehicle having an engine 3 and a motor generator 5.

In the hybrid vehicle, wheels 11 are driven by the engine 3 through a drive shaft 7 and a differential case 9 at a normal operation. At a high load operation, the motor generator 5 functions as a motor, which is power supplied with a battery 13, and assists to the drive shaft 7 connected to the differential case 9 and wheels 11.

The motor generator 5 functions as a generator when the hybrid vehicle decelerates or is braked so as to charge the battery 13 by transforming kinetic energy to electric energy.

The in-vehicle unit 1 of the embodiment of the present invention includes a current sensor 15 for detecting a discharge current I of the battery 13 and a voltage sensor 17 having an infinite resistance and connected in parallel with the battery 13 for detecting a terminal voltage V of the battery 13.

The in-vehicle unit 1 includes a interface circuit 21, hereafter denoted as I/F, for A/D transformation and a microcomputer 23. The outputs of the current and voltage sensors 15, 17 are input to the microcomputer 23 through the I/F 21.

The microcomputer 23 has a central processing unit (CPU) 23a for processing programs, a ROM 23c for storing the programs processed by the CPU 23a, and a RAM 23b having a working area for processing the programs with the CPU 23a and a storing area for storing several data.

FIG. 2 shows a flowchart of processing the programs with the CPU 23a for the above described in-vehicle unit 1. When the battery 13 starts a low rate discharge, the discharge current I and the terminal voltage V are measured with the current sensor 15 and the voltage sensor 17 and the CPU 23a receives the pair of the current-voltage data for calculating the intrinsic resistance of the battery 13. At step S1, the I-V characteristic with increase of the discharge current is obtained and a quadratic approximate expression of the current increasing curve $L_1$ of Eq. 1 is determined with least-square method.

At step S2 , the CPU 23a receives the I-V data when the current decreases and determines a quadratic approximate expression of the current decreasing curve $L_2$ of Eq. 2 with least-square method. The current sensor 15, voltage sensor 17 and CPU 23a form a measuring means. The CPU 23a calculates the approximate expressions.

At steps S3 and S4, the CPU 23a determines the tangential angles $R_1(=2a_1I_p+b_1$, Eq. 3) and $R_2$ ($=2a_2I_p+b_2$, Eq. 4) of the current increasing and decreasing curves $L_1$ and $L_2$ at the peak current $I_p$.

At step S5, the CPU 23a determines the range of the intrinsic resistance R, $[\{(R_1+R_2)/2\}>R>R_2]$, from the values of $R_1$ and $R_2$. At step S6, the CPU 23a determines the center value in the range of the intrinsic resistance as a tentative intrinsic resistance $R_t=(R_1+3R_2)/4$. At step S7, the CPU 23a assumes the tentative intrinsic resistance $R_t$ as the intrinsic resistance R and determines a tentative discharge current $I_{maxt}$ of the tentative maximum polarization time.

At steps S8, S9 and S10, the CPU 23a determines the unknown $\gamma$ and the intrinsic resistance R by solving the simultaneous Eqs. 9 and 12. Accordingly, the CPU 23a has means for determining the intrinsic resistance.

Solving the simultaneous Eqs. 9 and 12 determines the intrinsic resistance of the battery at the low rate discharge in which the maximum polarization is not clearly known.

Industrial Applicability

According to the inventions of claims 1 and 5, a first and second relational expressions, which include unknowns of an intrinsic resistance and intrinsic maximum polarization time and a known of a tentative maximum polarization time, are solved to obtain the intrinsic resistance. The present invention provides a method of measuring the intrinsic resistance of a battery at a low rate discharge which does not clearly define a maximum polarization time, and an apparatus of the same.

According to the invention of claim 2, the method provides accurately the intrinsic resistance from the first and second relational expressions.

According to the invention of claim 3, the method defines the range of the intrinsic resistance so that the intrinsic resistance of the battery is determined accurately.

According to the invention of claim 4, the method defines the center value of the range of the intrinsic resistance as the tentative intrinsic resistance to minimize a difference between the intrinsic and tentative resistances so that the intrinsic resistance of the battery is determined accurately.

**Claims**

1.  A method of measuring an intrinsic resistance of a battery comprising the steps of:

    measuring periodically a discharge current and a terminal voltage responding to the discharge current at a low rate discharge of the battery;
    determining a first approximate expression of the terminal voltage with respect to the increasing discharge current and a second approximate expression of the terminal voltage with respect to the decreasing discharge current based on the measured discharge current and terminal voltage;
    defining a range of the intrinsic resistance based on the first and second approximate expressions;

assuming a resistance in the range of the intrinsic resistance as a tentative intrinsic resistance;
determining a tentative maximum polarization time from the second approximate expression and the tentative intrinsic resistance; and
determining the intrinsic resistance from two relational expressions including the intrinsic resistance, an intrinsic maximum polarization time and the tentative maximum polarization time.

2. The method as claimed in claim 1, wherein said two relational expressions comprise:

a first relational expression given by equating the intrinsic resistance to a formula of { (a period of time between a start of discharge and the intrinsic maximum polarization time) / (a period of time between the start of discharge and the tentative maximum polarization time)}×(a maximum value in the range of the intrinsic resistance) +{(a period of time between the intrinsic maximum polarization time and the tentative maximum polarization time)/ (the period of time between the start of discharge and the tentative maximum polarization time)}×(a minimum value in the range of the intrinsic resistance); and
a second relational expression given by equating the intrinsic resistance to a formula of a differential equation of the second approximate expression substituted the discharge current with a current of a formula of (a peak current)×{(the period of time between the intrinsic and tentative maximum polarization times)/(a period of time between a peak current time and the tentative maximum polarization time).

3. The method as claimed in claim 1 or 2, further comprising the steps of:

differentiating the first approximate expression with respect to the discharge current to obtain a first amount of change;
differentiating the second approximate expression with respect to the discharge current to obtain a second amount of change; and
defining the range of the intrinsic resistance between (the first amount of change + the second amount of change) /2 and (the second amount of change) at the peak current.

4. The method as claimed in any one of claims 1-3, wherein the center value of the range of the intrinsic resistance is the tentative intrinsic resistance.

5. An apparatus for measuring an intrinsic resistance of a battery comprising:

a current sensor for measuring a discharge current of a battery at a low rate discharge;
a voltage sensor for measuring a terminal voltage of the battery responding to the discharge current;
an interface circuit for converting the measured voltage from analog to digital; and
a microcomputer having a CPU, a RAM and a ROM,
wherein the CPU
receives data of the measured current and voltage from the interface circuit;
calculates a first approximate expression of the terminal voltage with respect to the increasing discharge current and a second approximate expression of the terminal voltage with respect to the decreasing discharge current from the measured discharge current and terminal voltage;
defines a range of the intrinsic resistance from the first and second approximate expressions;
assumes a resistance in the range of the intrinsic resistance as a tentative intrinsic resistance;
determines a tentative maximum polarization time from the second expression and the tentative intrinsic resistance; and
determines the intrinsic resistance from two relational expressions including the intrinsic resistance, an intrinsic maximum polarization time and the tentative maximum polarization time.

F I G. 1

$$\text{PROCESS FOR MEASURING INTRINSIC RESISTANCE}$$

ACQUIRE I-V CHARACTERISTIC OF INCREASING DISCHARGE CURRENT & CALCULATE CURRENT INCREASING CURVE L 1 — S 1

ACQUIRE I-V CHARACTERISTIC OF DECREASING DISCHARGE CURRENT & CALCULATE CURRENT INCREASING CURVE L 2 — S 2

$$R_1 = 2a_1 I_p + b_1$$ — S 3

$$R_2 = 2a_2 I_p + b_2$$ — S 4

$$\frac{R_1 + R_2}{2} > R > R_2$$ — S 5

$$R_t = (R_1 + 3R_2)/4$$ — S 6

$$I_{maxt} = (b_2 - R_t) \, 2a_2$$ — S 7

$$R = \frac{t_1 + \gamma}{t_1 + t_2{}'} \alpha + \frac{t_2{}' - \gamma}{t_1 + t_2{}'} \beta$$ — S 8

$$R = 2a_2 I_p \times \frac{t_2{}' - \gamma}{t_2{}'} + b_2$$ — S 9

CALCULATE R, $\gamma$ — S 10

END

F I G. 2

TERMINAL VOLTAGE V

F I G. 3

F I G. 4

F I G. 5

CONCENTRATION
POLARIZATION $V_{pol}$

MAXIMUM
CONCENTRATION
POLARIZATION

CONCENTRATION
POLARIZATION AT $I_p$

DISCHARGE
TIME t

START OF
DISCHARGE

PERIOD OF TIME
OF INCREASING
DISCHARGE
CURRENT

PERIOD OF TIME
OF DECREASING
DISCHARGE
CURRENT

TERMINATION OF
DISCHARGE

F I G. 6 A

F I G. 6 B

EP 1 712 924 A1

TERMINAL VOLTAGE V

$e_o$

INCREASING DISCHARGE CURRENT

DECREASING DISCHARGE CURRENT

$I_p$

DISCHARGE CURRENT I

F I G. 7

## INTERNATIONAL SEARCH REPORT

| | International application No. |
|---|---|
| | PCT/JP2005/000679 |

**A. CLASSIFICATION OF SUBJECT MATTER**
Int.Cl$^7$ G01R31/36

According to International Patent Classification (IPC) or to both national classification and IPC

**B. FIELDS SEARCHED**

Minimum documentation searched (classification system followed by classification symbols)
Int.Cl$^7$ G01R31/36

Documentation searched other than minimum documentation to the extent that such documents are included in the fields searched
Jitsuyo Shinan Koho 1922-1996 Jitsuyo Shinan Toroku Koho 1996-2005
Kokai Jitsuyo Shinan Koho 1971-2005 Toroku Jitsuyo Shinan Koho 1994-2005

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2003-177163 A (Yazaki Corp.),<br>27 June, 2003 (27.06.03),<br>Full text; all drawings<br>& US 6677729 B2 | 1-5 |
| A | JP 2003-177164 A (Yazaki Corp.),<br>27 June, 2003 (27.06.03),<br>Full text; all drawings<br>& US 6661202 B2      & DE 10235008 A1 | 1-5 |

☐ Further documents are listed in the continuation of Box C. ☐ See patent family annex.

| | | |
|---|---|---|
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| 06 April, 2005 (06.04.05) | 19 April, 2005 (19.04.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003115331 A